# EUROPEAN PATENT APPLICATION

(11) **EP 2 581 683 A1**
(43) Date of publication of application: **17.04.2013**
(21) Application number: 11425248.9
(22) Date of filing: 11.10.2011
(51) Int. Cl.: F24J 2/04, H01L 31/042, H01L 31/052

(54) **Self supporting module, integrated with photovoltaic panels, for the coverage of buildings**

(71) Applicant: Sicit S.p.A., 62027 San Severino Marche (MC) (IT)
(72) Inventor: Ranzuglia, Remo, 62027 San Severino Marche (MC) (IT)
(74) Representative: Baldi, Claudio

(57) **Abstract**

The present invention relates to a self-supporting module for the roof coverage of buildings, consisting of a rectangular shell element (1) that includes a supporting structure (A) made of steel profiles, a layer of insulation (B) fixed below that supporting structure (A), an outer component (C) made of a series of coplanar photovoltaic panels (PV), fixed on top of that supporting structure (A) and an air cavity (D) placed between the layer of insulation (B) and the outer component (C).

## Description

The present invention relates to a modular, self supporting structure, for the roof coverage of buildings, particularly roofing shed, incorporating a layer of photovoltaic panels that are integrated with this structure contributing to increase the characteristics of mechanical strength, insulation and waterproofing of the structure.

To better understand the originality of the roof structure according to the invention, it is considered appropriate to describe how a shed roof structure is made at present.

The traditional solution requires the assembly on site of a structure composed of the following elements:
- a steel structure which is the secondary frame and is anchored to the main roof beams of the building. The roof beams are usually made of vibrated or compressed reinforced concrete or of steel;
- a series of steel purlins, which are fixed above the aforesaid structure with the task of distributing the load on the secondary frame;
- a roofing insulation, made of sandwich panels having two sheets of steel, with an interposed insulating layer of polyurethane foam or mineral wool, which are fixed above those purlins with the main function of waterproofing and insulation.

The combination of these three elements is in itself a roof structure "finished" in the sense of being able to perform structural functions, thermal insulation and waterproofing.

If it is required to install a photovoltaic plant on the roof, the said "finished" structure is today commonly integrated with the following elements:
- a frame made of steel profiles, anchored above the aforementioned "sandwich" panels, with the task of acting as a raised support structure for mounting the photovoltaic panels;
- a series of photovoltaic panels that are perched and fixed on the above steel frame;

From this simple description it can be seen that actually the solar panels do not currently integrate with the underlying "finished" roof structure from the point of view of enhancing its mechanical properties, thermal insulation and waterproofing.

Among other things, it has also been noticed that these sandwich panels, while incorporating a double sheet of steel, are unable to provide any contribution to the underlying structural steel frame which is the secondary frame and is anchored to the main roof beams of the building.

This inability is due to the fact that these steel sheets - which could make an appreciable contribution under tensile stress ― are found on the top portion of the element subjected to bending moment and therefore in an area where there are only compressive stresses.

The purpose of this invention is to realize a self supporting modular structure, integrated with photovoltaic panels and thermal insulation panels, which is then considered to be prefabricated and allows itself to then be transported and installed on the construction site of the building.

A further aim of the present invention is to realize a self supporting modular structure, of the type mentioned above, in which all the components contribute to the overall bearing capacity of the structure, resulting in an optimized use of all the construction materials.

In other words, you can see this modular structure as per the invention as an architectural integration of photovoltaics, which would ensure, in addition to the production of electricity, the following typical functions of a building:
- the water-proofing and the subsequent sealing of the building structure;
- mechanical strength comparable to that of a conventional building roof element;
- a thermal insulation that does not compromise the performance of the building.

These and other objectives have been achieved by the modular structure built according to the invention, whose innovative features, primary and secondary, are described in the appended claims.

The modular integrated structure as per the invention proposes a roof element consisting of a prefabricated shell, which is able to completely replace the secondary frame of the roof beams and the cladding system used in the traditional roofs of industrial buildings.

Within the prefabricated shell element, of rectangular shape, one can distinguish the following main components:
- a supporting structure made of two or more longitudinal steel profiles, separated by a spacing equal to the width of the photovoltaic panels and with the aforesaid longitudinal profiles being connected by tubular cross members;
- a panel of insulation, such as the sandwich panel described above, which is fixed below the supporting structure which goes to make the visible roof surface;
- a series of solar panels placed on top of that supporting structure;
- metallic elements on the top portion of the steel profiles for supporting, fixing and sealing the photovoltaic surface completing the shell element.

It is to be highlighted that within the prefabricated shell as per the invention, the photovoltaic surface alongwith its supporting elements in addition to producing energy also forms an integral part of the shell itself, making it integral for the correct functioning of the structure in terms of water-proofing, increasing the mechanical resistance and thermal insulation. Also, we can observe that the insulation panel, that is part of the lower portion of the shell element, is under tensile stress, due to which the steel sheets of the sandwich panel can provide a significant contribution to the aforesaid primary supporting structure (longitudinal profiles and cross tubulars) towards the total bearing capacity of the element.

According to the invention, the presence of the insulation panel on the lower portion of the shell element allows in case of a building fire, for the same panel to serve as a flame-resistant protective screen for the above supporting structure, without having to pay, as currently happens, the costs to cover the ceiling of the building with special heat-resistant materials. The structural configuration and the benefits springing from such a shell element will be clearer with the description that follows. The attached drawing sheets referred to have only illustrative value and are not limiting in any manner:
- fig. 1 is a cross section of the prefabricated shell element according to the invention;
- fig. 2 shows an isometric representation of the prefabricated shell element according to the invention;
- fig. 3 shows an enlarged particular of the construction of the prefabricated shell element according to the invention, sectioned transversely after being placed side by side and attached to an identical copy of shell element;
- figs. 4A and 4B show an isometric representation of the shell element according to the invention fully equipped with photovoltaic panels and ventilation windows, with the windows shown closed in fig. 4A and open in fig. 4B;
- fig. 5 shows the shell element assembled according to the invention;
- fig. 6 shows a cross section of a couple of shell elements, before the photovoltaic panels are installed to complete them;
- fig. 7 shows a cross section of a couple of shell elements, after the photovoltaic panels are installed to complete them.

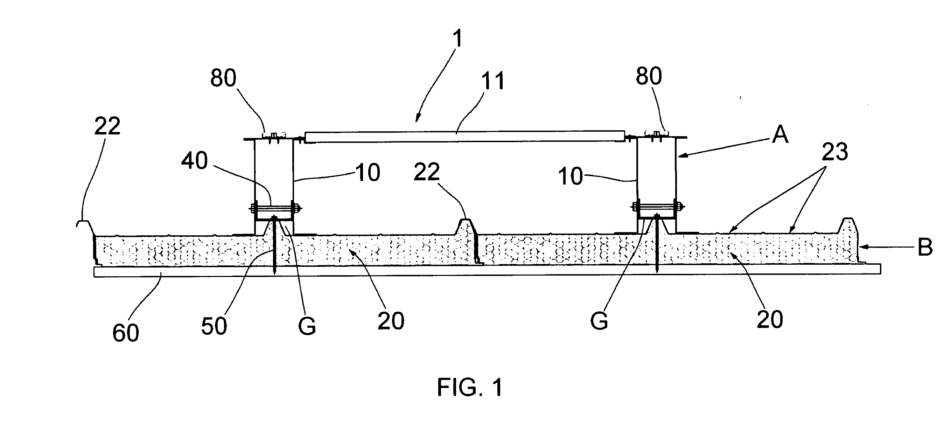

With reference to figures 1, 2 and 3, the modular integrated structure according to the invention consists of a rectangular prefabricated shell element (1) for roofs, within which we can distinguish the following main components:
- a supporting frame (A), made with a pair of parallel steel beams (10) oriented longitudinally and connected by tubular cross members (11);
- a layer of insulation (B) set below the supporting framework (A) consisting of a single or a series of coplanar insulation panels of sandwich type (20), each of which is made of a pair of steel sheets with an intermediate layer of insulating material (21);
- an outer component (C) made of a series of coplanar photovoltaic panels (PV), fixed on top of that supporting framework structure (A).

Please note that on the attached visual representations the top metal sheet (20a) of the insulation panel (20) has a corrugated profile, while the bottom metal sheet (20b) has a straight profile, but the top and bottom metal sheets can be both of straight profiles without affecting the function of the sandwich panel within the modular structure in question.

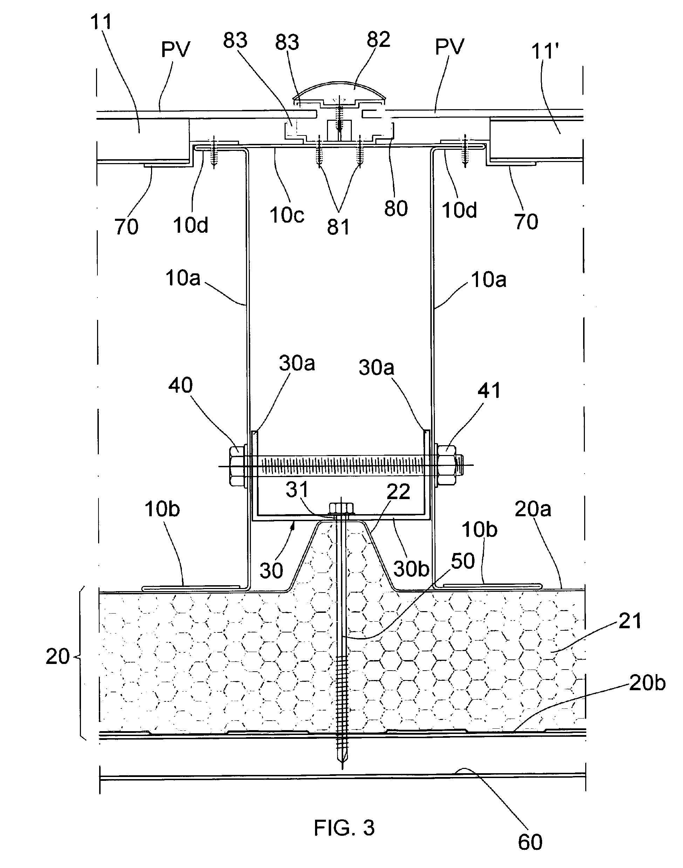

With particular reference to fig. 3, note that each steel profile (10) has a cross section of "Ω" type, within which we can distinguish:
- a pair of vertical webs (10a), having a base consisting of two horizontal flanges (10b) protruding outward;
- a horizontal top flange(10c), having two terminal sections (10d) that protrude outside the vertical webs (10a).

The connection of the insulation panel (20) to the above supporting framework (A) is done using a metal joint (G) which is interposed between the steel profile (10) and the insulation panel (20).

More precisely, this joint (G) consists of a "U" steel element (30) placed between the vertical webs (10a) of the "Ω" profile (10) so that the flanges (30a) of the "U" are parallel to the vertical webs (10a) of the "Ω", while the web (30b) of the "U" (30) is in contact with the upper portion of the corrugated steel sheet (20a). Horizontal lower flanges (10b) of the main profile (10) are in contact with the upper steel sheet (20a) of the panel, one on the left and one on the right of the protrusion(22) of the corrugated surface, as shown in Fig.3.

The horizontal web(30b) of the "U" (30) has one or more central bores (31). The "U" (30) and the main steel profile (10) are joined using a horizontally driven bolt (40) and nut (41) ― with the horizontal bolt interlocking the vertical webs (10a) of the "Ω" and the flanges(30a) of the "U", while the "U" and the sandwich panel are joined using vertically driven self-tapping screws (50).These screws vertically passe through the central bores (31) and the sandwich panel (20) to finally constrain a tubular steel profile (60) which runs laterally below the panel (20).

As has been mentioned before, the longitudinal steel profiles (10) are connected to each other using tubular elements (11). These tubular elements are joined using "Z" steel profiles (70) to the terminal sections (10d) of the horizontal flange (10c) of the "Ω" (10).

These tubular elements form the supporting structure for the photovoltaic panels (PV). These photovoltaic panels are fixed on the longitudinal "Ω" using an aluminium profile (80) connected to the "Ω"'s horizontal flange (10c) with common self-tapping screws (81).

Aluminium profiles (80-82) are used to constrain each pair of photovoltaic panels (PV) along their longitudinal edges. These aluminum profiles are composed of 2 parts ― one (80) on the top portion of the "Ω" supporting the PV from below, one (82) above the photovoltaic panels and fixed on the lower part (80). The photovoltaic surface, consisting of the solar panels(PV), their respective aluminium supporting profiles (80,82) and the steel tubulars (11), guarantees the stability of the horizontal steel flange (10c), thereby increasing the bearing capacity of the "Ω" profile.

The impermeability of the photovoltaic surface (C) is provided by the gaskets (83) placed between the photovoltaic panels (PV) and the aluminium profiles (80,82) in longitudinal direction and also between every panel in transversal direction.

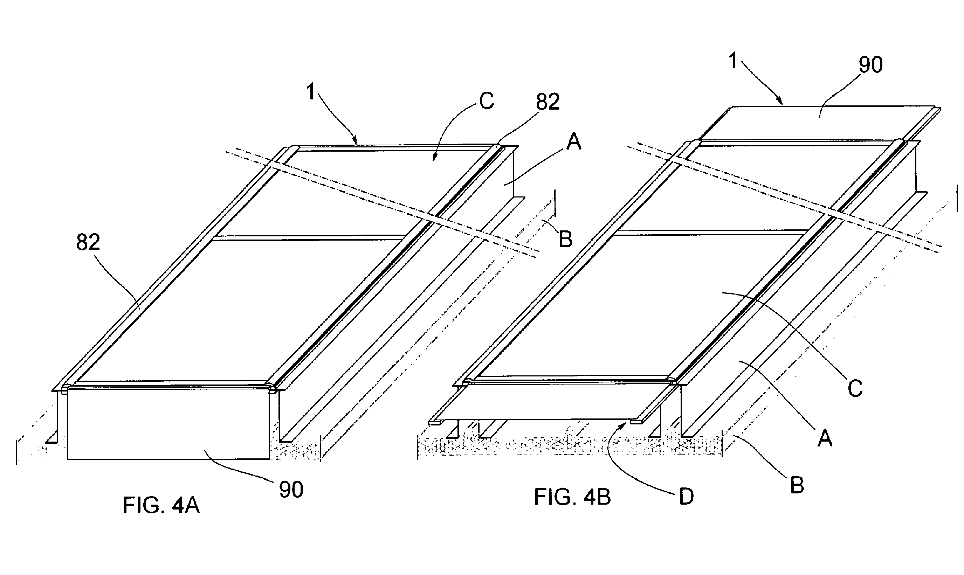

Now referring to the fig. 4, an air cavity (D) is created between the insulation layer (B) at the bottom, and the photovoltaic covering (C) at the top. This cavity (D) ensures an elevated level of ventilation to the lower surface of the photovoltaic panels (PV), especially desired in the presence of high environmental temperatures with the aim of cooling these surfaces. Instead, in the presence of low environmental temperatures, the same air cavity, closed at its extremities, becomes an air compartment contributing to an increased insulation for the roof.

In particular, referring to the fig. 4A & 4B, there are shutters (90) on the short sides of the prefabricated shell element (1) that can rotate such as "vasistas" windows, to aid or inhibit the ventilation through the air cavity (D). Basically, we can say that the prefabricated shell element as per the invention represents an energy saving solution because its structure is capable of regulating simultaneously:
- the humidity and temperature conditions inside the building;
- the working conditions for the photovoltaic panels (PV) avoiding their overheating by means of natural ventilation through the internal zone of the shell.

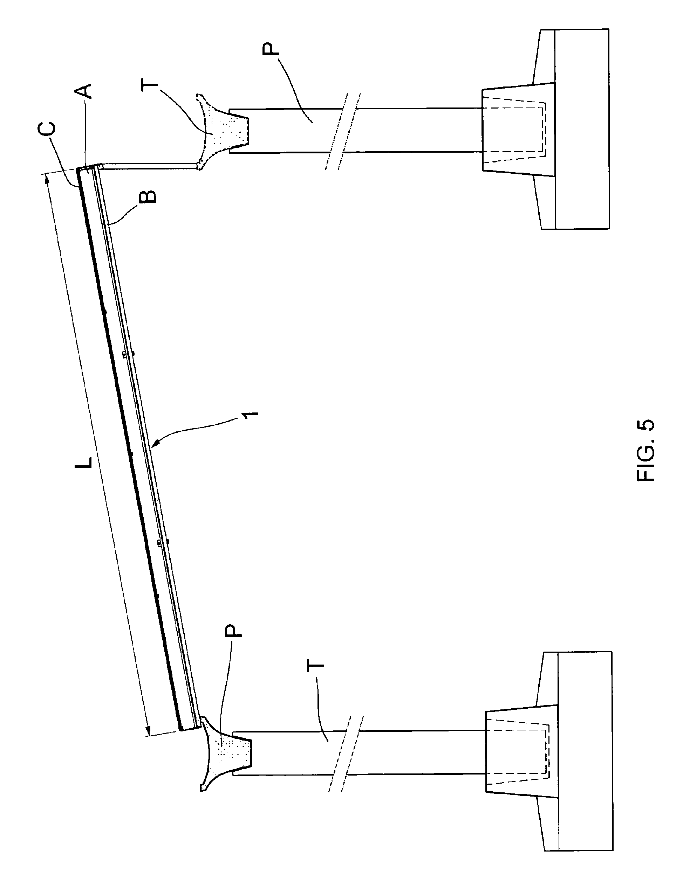

It is to be noted that the spacing between the longitudinal steel profiles (10) is almost equal to the width of the photovoltaic panels (PV), while the length of the shell varies with the inclination of the shed and the distance between the columns (P). As seen in the fig. 5, this shell element is fixed on the top of principal beams (T) that are supported by columns (P).

A last clarification has to be reported referring to the installation process for the covering photovoltaic surface (C) above these prefabricated shell elements (1).

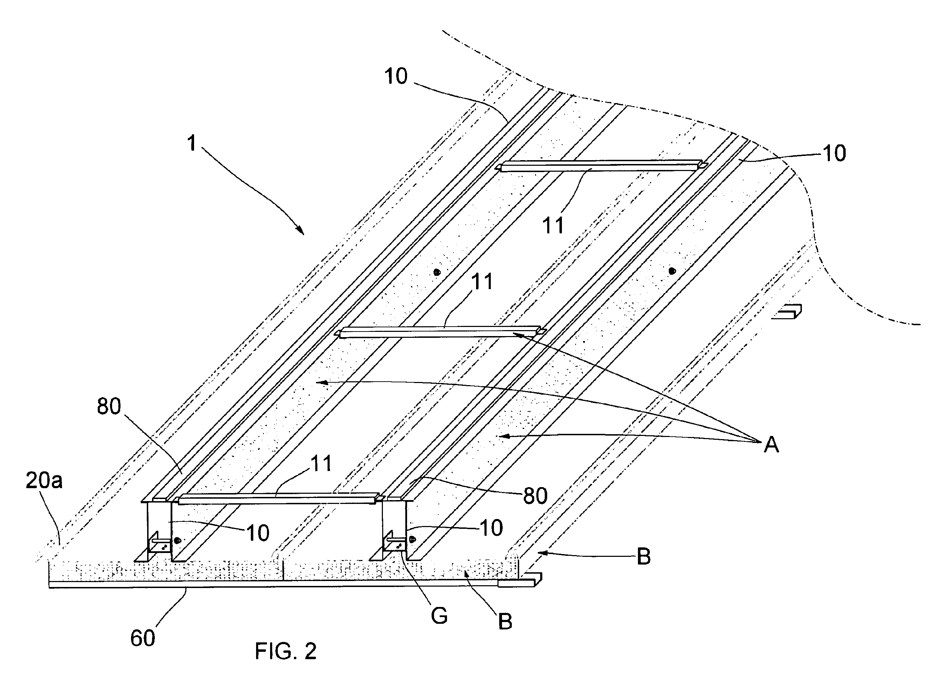

As shown in fig 1 & 2, the prefabricated shell element (1) includes the lower insulation layer (B) and the above main structure (A) completed with the cross steel tubulars (11) fixed between each pair of longitudinal profiles (10).

This prefabricated shell element (1) includes also a series of tubular profiles (60) that runs transversely under the sandwich panel (20), but does not include the photovoltaic panels (PV) because it's more advantageous, in terms of time and manpower, to install this covering layer on the construction site.

Still referring to fig 1 & 2, each prefabricated shell has on its longitudinal edges a part of the sandwich panel that protrudes outward.

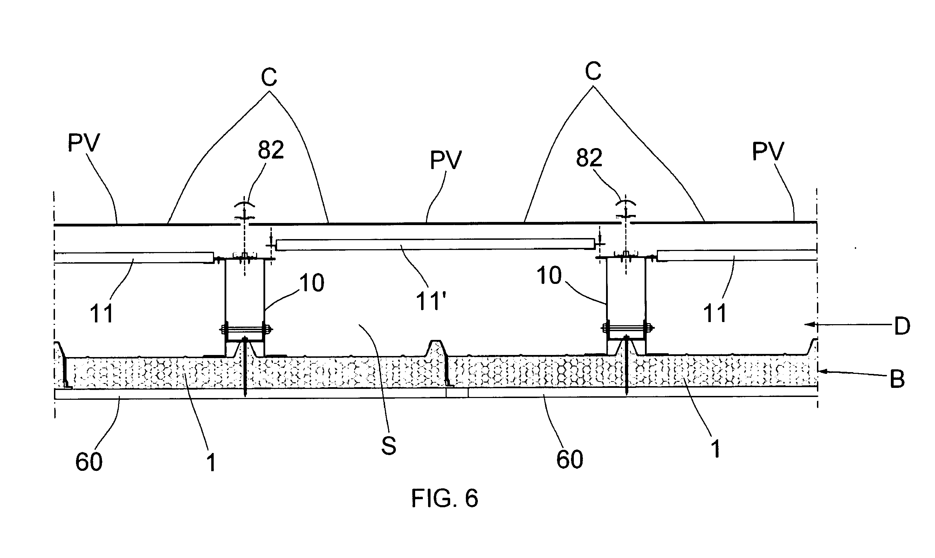

Joining two prefabricated shells side-by-side we must take care that the protruding parts, belonging respectively to the first and the second shell, go to fit exactly between them, just as shown in fig.6.

In such a circumstance, between the pair of adjacent longitudinal profiles (10) belonging respectively to the first and second shell, we have a free space identical to that which exists between the pair of longitudinal profiles (10) of each shell, then appropriate to be covered at the top with the photovoltaic panels (PV).

Therefore between the pair of adjacent longitudinal profiles (10) belonging respectively to the first and second shell, we can install the cross tubulars (11') aligned with the cross tubulars (11) already mounted on the prefabricated shell.

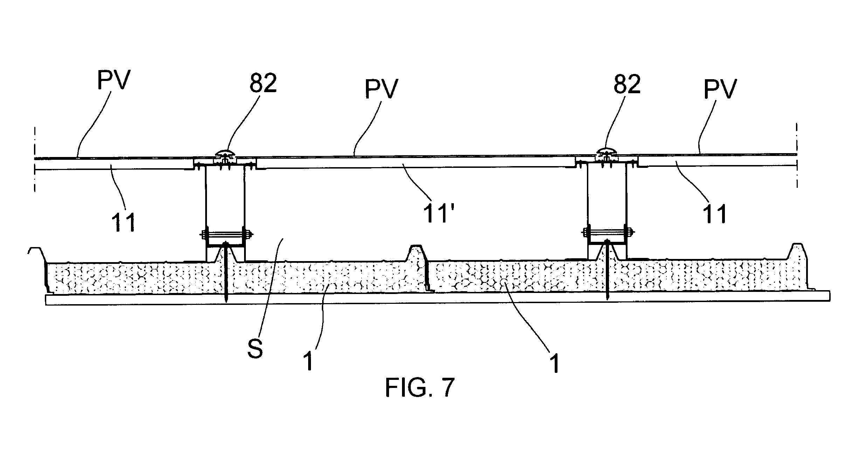

The fig.7 shows the roof cross-section after the installation of all the photovoltaic panels on the prefabricated shells.

## Claims

1. Self supporting module for the coverage of buildings, consisting of a rectangular shell element (1) composed by:
- a supporting frame (A), made with two or more parallel steel beams (10) oriented longitudinally and connected by tubular cross members (11);
- a layer of insulation (B) set below the supporting framework (A) consisting of a single or a series of coplanar insulation panels (20);
- an outer component (C) made of a series of coplanar photovoltaic panels (PV) fixed on top of that supporting framework structure (A);
- an air cavity (D) between the insulation layer (B) at the bottom, and the photovoltaic covering (C) at the top.

2. Self supporting module according to the previous claim, **characterized by** the fact that each insulation panel (20) is composed of two steel sheets, with a layer of insulating material (21) interposed between the top metal sheet (20a) and the bottom metal sheet (20b).

3. Self supporting module according to the claim 1), **characterized by** the fact that each steel profile (10) has a cross section of "Ω" type, within which we can distinguish:
- a pair of vertical webs (10a), having a base consisting of two horizontal flanges (10b) protruding outward;
- a horizontal top flange (10c), having two terminal sections (10d) that protrude outside the vertical webs (10a).

4. Self supporting module according to one or more previous claims, **characterized by** the fact that there are tubular cross members (11) that are fixed on the terminal sections (10d) and contribute to the support of the photovoltaic panels (PV).

5. Self supporting module according to one or more previous claims, **characterized by** the fact that it has a joint (G) for the connection between the insulating panel (20) and the upper bearing frame (A).

6. Self supporting module according to the previous claim, **characterized by** the fact that this joint (G) consists of a "U" steel element (30) placed between the vertical webs (10a) of the steel profile (10) so that the flanges (30a) of the "U" are parallel to the vertical webs (10a) of the "Ω", while the horizontal lower flanges (10b) of the steel profile are in contact with the upper steel sheet (20a) of the sandwich panel.

7. Self supporting module according to one or more previous claims, **characterized by** the fact that the steel profiles (10) are joined with the "U" element using a horizontally driven bolt (40) and nut (41) ― with the horizontal bolt interlocking the vertical webs (10a) of the "Ω" and the flanges (30a) of the "U".

8. Self supporting module according to one or more previous claims, **characterized by** the fact that the "U" and the sandwich panel are joined using one or more vertically driven self-tapping screws (50). These screws vertically passe through the bores in the center of "U"'s web (31) and cross the sandwich panel (20) to finally constrain a tubular steel profile (60) which runs transversely below the panel (20).

9. Self supporting module according to one or more previous claims, **characterized by** the fact that aluminium profiles (80-82) are used to constrain each pair of photovoltaic panels (PV) along their longitudinal edges. These aluminum profiles are composed of 2 parts ― one (80) on the top portion of the "Ω" supporting the PV from below, one (82) above the photovoltaic panels and fixed on the lower part (80) with the interposition of gaskets (83) placed between the photovoltaic panels (PV) and the aluminium profiles (80,82).

10. Self supporting module according to one or more previous claims, **characterized by** the fact that it has shutters (90) that can rotate, placed on the short sides of the prefabricated shell element (1). Opening or closing these shutters is possible to respectively aid or inhibit the ventilation through the air cavity (D).

11. Self supporting module according to one or more previous claims, **characterized by** the fact that each shell (1) has on its longitudinal edges a part (23) of the sandwich panel (20) that protrudes outward.
